(19) Europäisches Patentamt
European Patent Office
Office européen des brevets

(11) **EP 4 692 829 A1**

(12) **EUROPEAN PATENT APPLICATION**
published in accordance with Art. 153(4) EPC

(43) Date of publication:
**11.02.2026 Bulletin 2026/07**

(21) Application number: **24781153.2**

(22) Date of filing: **25.03.2024**

(51) International Patent Classification (IPC):
*G01R 31/40* (2020.01)     *G01R 22/06* (2006.01)
*G01R 15/18* (2006.01)     *G01R 31/382* (2019.01)

(52) Cooperative Patent Classification (CPC):
**G01R 31/40; G01R 15/18; G01R 22/06;**
**G01R 31/382; G01R 35/04**

(86) International application number:
**PCT/KR2024/003689**

(87) International publication number:
**WO 2024/205162 (03.10.2024 Gazette 2024/40)**

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**GE KH MA MD TN**

(30) Priority: **27.03.2023 KR 20230039834**

(71) Applicant: **Hanwha Solutions Corporation**
**Jung-gu**
**Seoul 04541 (KR)**

(72) Inventors:
• **PARK, Min Gi**
  **Seoul 04541 (KR)**
• **LEE, Joon Min**
  **Seoul 04541 (KR)**
• **PARK, Sung Youl**
  **Seoul 04541 (KR)**
• **KO, Tae Hoon**
  **Seoul 04541 (KR)**

(74) Representative: **Mooser, Sebastian Thomas**
**Wuesthoff & Wuesthoff**
**Patentanwälte und Rechtsanwalt PartG mbB**
**Schweigerstraße 2**
**81541 München (DE)**

(54) **METHOD FOR DETECTING INCORRECT INSTALLATION OF MEASUREMENT DEVICE AND ENERGY STORAGE SYSTEM USING SAME**

(57)     An energy storage system according to an aspect includes a processor identifying a first power amount of a load using first measurement information received from at least one measurement device, identifying a second power amount of the load using second measurement information received from the measurement device according to a change in a charged power amount of a battery, identifying power excessive fluctuation of the load based on a difference between the first power amount and the second power amount, and detecting incorrect installation of the measurement device based on the number of times the power excessive fluctuation has occurred.

FIG. 1

## Description

### Technical field

The present disclosure relates to a method for detecting incorrect installation of a measurement device and an energy storage system using the same.

### Background Art

Recently, interest in renewable energy sources that produce electricity using renewable energy, such as solar heat, solar energy, biomass, wind power, small hydro power, geothermal heat, marine energy, and waste energy has increased around the world. Because renewable energy sources have high output uncertainty, an energy storage system (ESS) is provided to guarantee the uncertainty.

Meanwhile, to measure the electrical quantity (load) of a grid) and a load, not only ESS but also a measurement device (e.g., current transducer (CT), energy meter (EM), etc.) is installed together.

If an operator incorrectly installs the measurement device (e.g., a reverse direction, a reverse phase, a non-connection, etc.), the measurement device cannot accurately measure current or power values. Accordingly, it may be difficult to normally operate power of the ESS. In this case, even though a load is connected to the ESS, no power may be generated and energy may be wasted. Or, excessive power may be generated in the load and system connected to the ESS, resulting in electrical damage.

### Disclosure

### Technical problem

The present disclosure provides a method for detecting incorrect installation of a measurement device and an energy storage system using the same. The present disclosure also provides a computer-readable recording medium on which a program for executing the above method on a computer is recorded. The technical problems to be solved are not limited to those described above, and other technical problems may exist.

### Technical solution

According to one aspect, an energy storage system includes a processor configured to identify a first power amount of a load using first measurement information received from at least one measurement device, identify second power amounts of the load using second measurement information received from the measurement device according to a change in a charged power amount of a battery, identify power excessive fluctuation of the load based on a difference between the first power amount and the second power amounts, and detect incorrect installation of the measurement device based on the number of times the power excessive fluctuation has occurred.

According to another aspect, a method for detecting incorrect installation of at least one measurement device includes identifying a first power amount of a load using first measurement information received from at least one measurement device, identifying second power amounts of the load using second measurement information received from the measurement device according to a change in a charged power amount of a battery, identifying power excessive fluctuation of the load based on a difference between the first power amount and the second power amounts, and detecting incorrect installation of the measurement device based on the number of times the power excessive fluctuation has occurred.

According to another aspect, a computer-readable recording medium includes a recording medium having recorded a program for causing a computer to execute the aforementioned method.

### Advantageous Effects

According to the present disclosure, incorrect installation of a measurement device may be simply detected using an algorithm controlled and calculated by a processor without an additional hardware configuration.

In addition, the present disclosure is a fundamental technology that may prevent incorrect installation of measurement devices and has the scalability to be applied to single-phase 2-wire/3-wire and even 3-phase systems.

In addition, according to the present disclosure, incorrect installation of a measurement device may be stably detected even in an unstable actual installation environment including imbalance in a grid and a load. Therefore, the present disclosure may provide a robust algorithm with low sensitivity to external factors.

In addition, according to the present disclosure, by satisfying national regulations that require country-specific system safety certification standards, not only the protection of the energy storage system but also the scalability of product installation may be guaranteed.

### Description of Drawings

FIG. 1 is a view schematically illustrating a system for detecting incorrect installation of a measurement device according to an embodiment.
FIG. 2 is a flowchart illustrating an example in which an energy storage system operates according to an embodiment.
FIG. 3 is a view illustrating an example of a detailed circuit diagram of an energy storage system according to an embodiment.

FIG. 4 is a view illustrating another example of a detailed circuit diagram of an energy storage system according to an embodiment.

FIG. 5 is a view illustrating an example of an equivalent circuit diagram of an energy storage system according to an embodiment.

FIG. 6 is a graph illustrating an example in which the amount of charging power of a battery is controlled according to an embodiment.

FIG. 7 is a flowchart illustrating an example in which an energy storage system operates according to an embodiment.

FIG. 8 is a view illustrating another example of a detailed circuit diagram of an energy storage system according to an embodiment.

FIG. 9 is a view illustrating another example of a detailed circuit diagram of an energy storage system according to an embodiment.

## Best Mode

An energy storage system according to one aspect includes a processor configured to identify a first power amount of a load using first measurement information received from at least one measurement device, identify a second power amount of the load using second measurement information received from the measurement device according to a change in a charged power amount of a battery, identify power excessive fluctuation of the load based on a difference between the first power amount and the second power amount, and detect incorrect installation of the measurement device based on the number of times the power excessive fluctuation has occurred.

## Mode for invention

The terms used in the embodiments are possibly selected from among currently well-known terms but may vary depending on the cases or intentions of those skilled in the art or on the advent of new technology, etc. In addition, in certain cases, there are terms arbitrarily selected by the applicant, and in this case, the meaning is described in detail in the relevant description. Therefore, terms used in the specification should be defined based on the meaning of the terms and the description throughout the specification, not just the name of the terms.

In the specification, unless explicitly described to the contrary, the word "comprise" or "include" is understood to imply the inclusion of stated constituent elements, not the exclusion of any other constituent elements

In addition, although the terms "first," "second," etc. used in the specification may be used herein to describe various elements, these elements should not be limited by these terms. These terms are only used to distinguish one element from another.

Hereinafter, embodiments according to the present disclosure are described in detail with reference to the accompanying drawings. The detailed description set forth below in conjunction with the accompanying drawings is intended to describe embodiments of the present disclosure and is not intended to represent the only embodiment in which the present disclosure may be practiced. In order to clearly describe the present disclosure in the drawings, parts unrelated to the description may be omitted, and like reference numerals may be used for like or similar components throughout the specification.

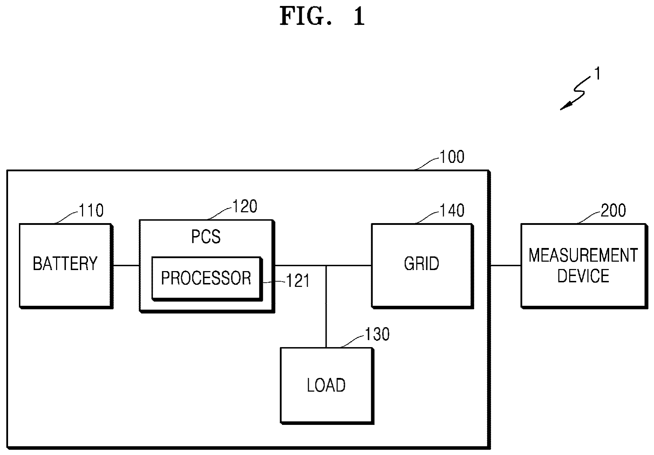

FIG. 1 is a view schematically illustrating a system for detecting incorrect installation of a measurement device according to an embodiment.

Referring to FIG. 1, a system for detecting incorrect installation of a measurement device (hereinafter referred to as an 'incorrect installation detection system') 1 includes an energy storage system (ESS) 100 and a measurement device 200. Meanwhile, in addition to the components shown in FIG. 1, other general-purpose components may be further included in the incorrect installation detection system 1.

The ESS 100 is a system that increases energy efficiency by controlling power demand and supply and includes a battery 110, a power conditioning device (PCS) 120, a load 130, and a grid 140. Meanwhile, in addition to the components shown in FIG. 1, other general-purpose components may be further included in the ESS 100.

The battery 110 is a device that stores power produced by a renewable energy source, power supplied from the grid 140, and supplies power as needed. For example, the battery may include at least one module and a plurality of battery cells included in each module.

The PCS 120 is a device that controls the overall operations of the components within the ESS 100 for power operation. For example, the PCS 1 may include an inverter, etc.

A processor 121 included in the PCS 120 may detect incorrect installation of the measurement device 200. The processor 121 may process instructions of a computer program by performing basic arithmetic, logic, and input/output operations. Here, the instructions may be provided from memory within the PCS 120 or from an external device. In addition, the processor 121 may generally control the operations of other components included in the PCS 120.

For example, the processor 121 may be implemented as an array of a plurality of logic gates or may be implemented as a combination of a general-purpose microprocessor and a memory storing a program that may be executed on the microprocessor. For example, processor 121 may include a general-purpose processor, a central processing unit (CPU), a graphics processing unit (GPU), a neural network processing unit (NPU), a microprocessor, a digital signal processor (DSP), a controller, a microcontroller, a state machine, etc. In some circumstances, the processor 160 may include an application-specific integrated circuit (ASIC), a programmable logic device (PLD), a field programmable gate array (FPGA), etc. For example, the processor 121 may refer to a combination of processing devices, such as a combination of a DSP and a microprocessor, a combination of a plurality of microprocessors, a combination of one or more microprocessors combined with a DSP core, or any other combinations of such components. For example, the processor 121 may include a microcontroller unit (MCU) for power control.

Meanwhile, in FIG. 1, the processor 121 is shown as being included in the PCS 120 but is not limited thereto. In other words, the processor 121 may be included in a device other than the PCS 120 and may detect incorrect installation of the measurement device 200.

The measurement device 200 is a device that is physically connected to the ESS 100 and measures the amount of power inside the ESS 100. For example, the measurement device 200 may measure power flow of the grid 140 and predict the power amount of the grid 140, the power amount of the load 130, etc.

The measurement device 200 may include a current transducer (CT) or an energy meter (EM). However, the present disclosure is not limited thereto, and if necessary, two or more types of measurement devices 200 may be included in the incorrect installation detection system 1. In addition, depending on a structure of the ESS 100, one or two or more measurement devices may be included in the incorrect installation detection system 1.

The measurement device 200 may be installed at an appropriate position inside or outside the ESS 100 to measure values required to be measured, such as the power amount of the grid 140 and the power amount of the load 130. In addition, an installation position of the measurement device 200 is not limited to any one position.

While the measurement device 200 is installed manually by an operator, it is a consumable product and requires periodic replacement and maintenance. In addition, the measurement device 200 may be incorrectly installed due to an operator error during an installation or replacement process. Therefore, a method is needed to enable normal power operation of the entire grid and to properly utilize power from renewable energy sources and the battery 110.

The processor 121 according to an embodiment detects incorrect installation of the measurement device 200 through whether the power amount of the load 130 fluctuates excessively due to a change in the charged power amount of the battery 110. Hereinafter, the operations of the ESS 100 and the measurement device 200 according to an embodiment of the present disclosure are described in detail with reference to the drawings.

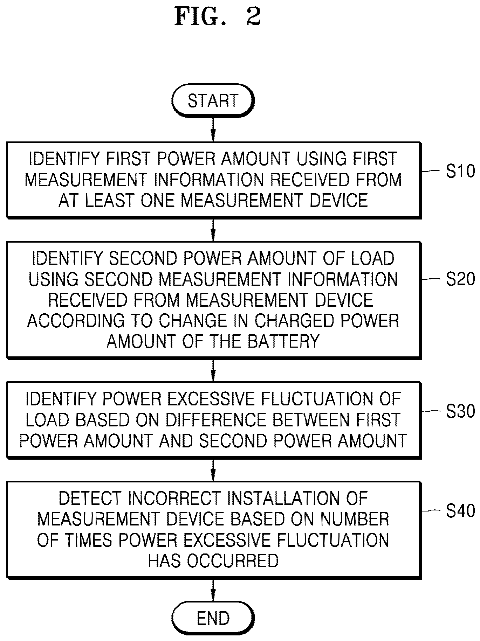

FIG. 2 is a flowchart illustrating an example in which an energy storage system operates according to an embodiment.

In operation S10, the processor 121 identifies a first power amount of the load 130 using first measurement information received from at least one measurement device 200.

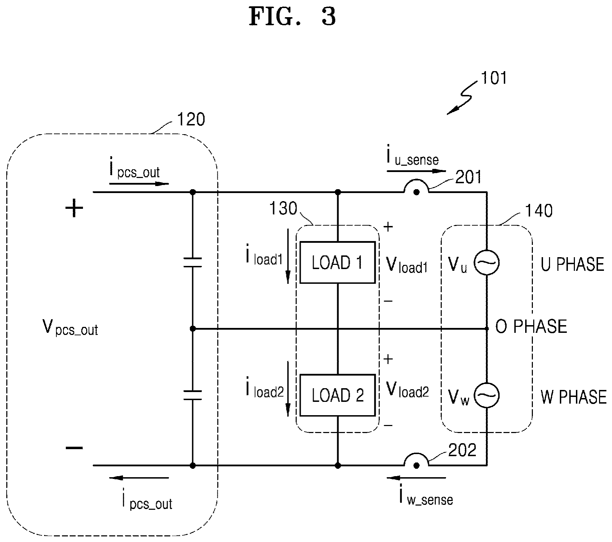

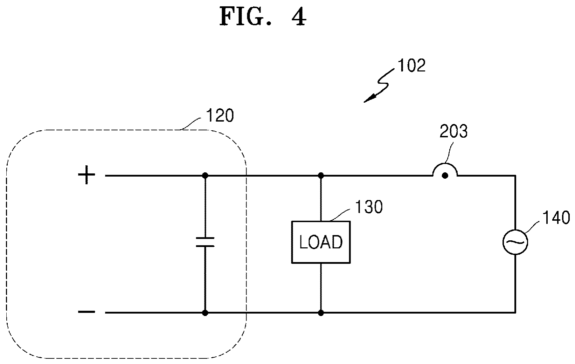

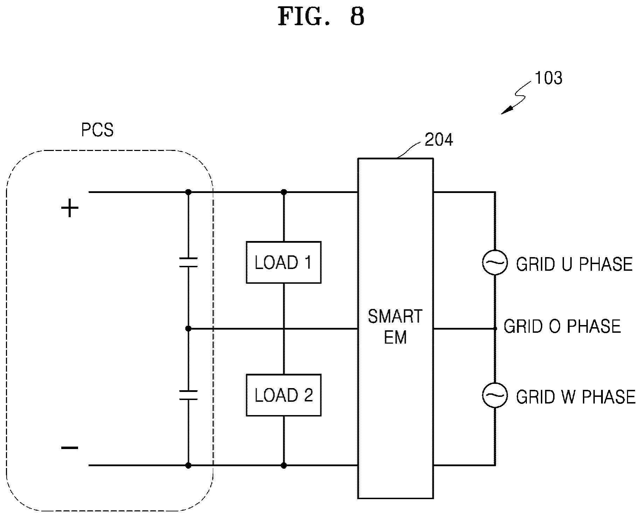

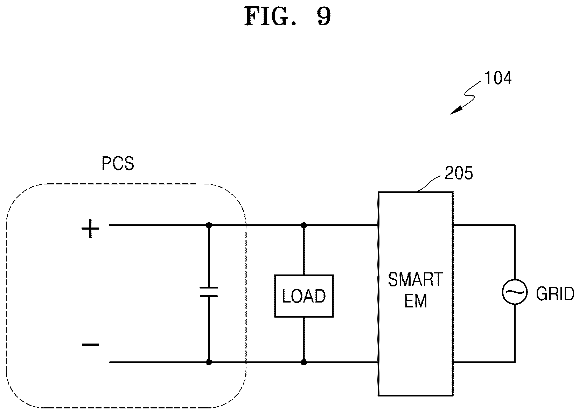

For example, depending on the structure of the ESS 100 (e.g., single-phase 2-wire type, single-phase 3-wire type, etc.), an installation position and the number of installed measurement devices 200 may vary. As an example, an example of a single-phase 3-wire system when the measurement device 200 is a current transducer (CT) is shown in FIG. 3. In addition, a single-phase, 2-wire system when the measurement device 200 is a CT is shown in FIG. 4. As another example, a single-phase 3-wire system when the measurement device 200 is an energy meter (EM) is shown in FIG. 8. In addition, a single-phase, 2-wire system when the measurement device 200 is an EM is shown in FIG. 9. However, the present disclosure is not limited thereto, and the operation of the processor 121 described with reference to FIGS. 2 to 9 may be applied even when the ESS 100 is a 3-phase system.

In addition, measurement information received from the measurement device 200 may vary depending on the type of the measurement device 200. As an example, when the measurement device 200 is a CT, the measurement information may include a current value of the system. As another example, when the measurement device 200 is an EM, the measurement information may include the amount of power in the system.

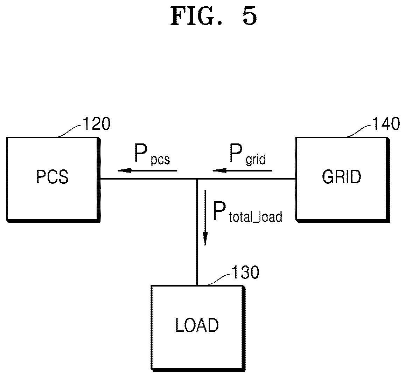

The processor 121 may identify the power amount of the load 130 through a difference between the power amount of the grid 140 and the power amount of the PCS 120 using the measurement information received from the measurement device 200. An example in which the processor 121 identifies the power amount of the load 130 is described below with reference to an equivalent circuit diagram of the ESS 100 shown in FIG. 5.

In detail, the processor 121 may identify the power amount of the grid 140 using the measurement information received from the measurement device 200 and a voltage value of the grid 140 measured inside the PCS 120. Here, the power amount of the PCS 120 may be measured inside the PCS 120. For example, the power amount of the PCS 120 may be a value corresponding to the charged power amount of the battery 110 controlled by the PCS 120.

Meanwhile, the first power amount of the load 130 may be a reference power amount when the charged power amount of the battery 110 is a reference value. The processor 121 determines incorrect installation of the measurement device 200 according to excessive fluctuation in power of the load 130 because the reference value is necessary to determine the excessive fluctuation in power of the load 130.

For example, when the reference value of the charged power amount is 0W, the reference power amount of the load 130 may be the power amount of the grid 140. However, the reference value of the charged power amount is not limited to 0W.

Therefore, when the charged power amount of the battery 110 is the reference value, the processor 121 may identify the reference power amount (hereinafter, referred to as a 'first power amount') of the load 130 using the measurement information (hereinafter, referred to as 'first measurement information') received from the measurement device 200.

In operation S20, the processor 121 identifies second power amounts of the load 130 using second measurement information received from the measurement device 200 according to a change in the charged power amount of the battery 110.

A variety of methods by which the processor 121 changes the charged power amount of the battery 110 may be applied. For example, the processor 121 may change the charged power amount of the battery 110 by repeatedly raising and lowering the charged power amount of the battery 110 in stages within a predefined time.

In operation S30, the processor 121 identifies power excessive fluctuation of the load 130 fluctuates excessively based on a difference between the first power amount and the second power amounts.

For example, the processor 121 may identify the minimum and maximum values among the second power amounts. In addition, the processor 121 may identify that power excessive fluctuation has occurred when a difference between the first power amount and any one of the minimum and maximum values exceeds a predefined value. Alternatively, the processor 121 may identify that power excessive fluctuation has occurred when an average value of the differences between the first power amount and the second power amounts exceeds a predefined value. In addition, there may be various methods for the processor 121 to identify whether the power of the load 130 fluctuates excessively.

In operation S40, the processor 121 detects incorrect installation of the measurement device 200 based on the number of times power excessive fluctuation has occurred.

For example, if the number of times power excessive fluctuation has occurred exceeds a predefined number, the processor 121 may determine that the measurement device 200 is incorrectly installed.

In general, in order to supply a constant amount of power to the load 130, even if the charged power amount of the battery 110 changes, the power amount of the grid 140 changes correspondingly. That is, there is virtually no possibility that a change pattern of the power amount of the load 130 will actually change to match a change pattern of the charged power amount of the battery 110. Therefore, when the charged power amount of the battery 110 changes suddenly, if the power amount of the load 130 excessively fluctuates, it may be considered that a problem has occurred in the measurement device 200.

When the processor 121 identifies whether the power of the load is excessively fluctuated while changing the charged power amount of the battery 110 within a predefined time, the processor 121 accumulatively identifies the number of times power excessive fluctuation has occurred during a plurality of periods based on the predefined time as one period.

Incorrect installation of the measurement device 200 refers to derailment or failure, incorrect installation in a reverse direction, incorrect installation in a reverse phase, O-phase connection, etc. of the measurement device 200. Detection of incorrect installation may be performed by an operator during initial installation of the product or may be performed on its own during normal operation of the product. In the related art in which incorrect installation is identified based only on whether a measurement value is close to 0, only derailment, failure, etc. of the measurement device 200 may be detected. Meanwhile, the processor 121 according to one aspect may detect all types of incorrect installations described above.

Meanwhile, the processor 121 may perform at least some of data analysis, processing, and resulting information generation to perform operations using at least one of machine learning, neural network, or deep learning algorithm as a rule-based or artificial intelligence algorithm. For example, it may include models, such as a neural network, convolutional neural network (CNN), deep neural network (DNN), and recurrent neural network (RNN).

According to the present disclosure, incorrect installation of the measurement device 200 may be simply detected using an algorithm controlled and calculated by the processor 121 without additional hardware configuration.

In addition, the present disclosure is a fundamental technology that may prevent incorrect installation of the measurement device 200 and has scalability that may be applied to single-phase 2-wire/3-wire and further 3-phase systems.

In addition, according to the present disclosure, incorrect installation of the measurement device 200 may be stably detected even in an unstable actual installation environment including imbalance of the grid 140 and the load 140. Therefore, the present disclosure may provide a robust algorithm with low sensitivity to external factors.

In addition, according to the present disclosure, by satisfying national regulations that require country-specific system safety certification standards, not only the protection of the ESS 100 but also the scalability of product installation may be guaranteed.

FIG. 3 is a view illustrating an example of a detailed circuit diagram of an energy storage system according to an embodiment.

FIG. 3 shows an example in which an ESS 101 is a single-phase 3-wire system. For example, in the ESS 101, a load 130 is connected between the PCS 120 and the grid 140, and a U-phase CT 201 and a W-phase CT 202 is connected between the load 130 and the grid 140. In the case of a single-phase 3-wire system, the U-phase CT 201 to measure flow of grid-based U-phase power and the W-phase CT 202 to measure flow of W-phase power may be installed.

As described above in operation S10 of FIG. 2, the power amount Ptotal_load of the load 130 may be identified through a difference between the power amount Pgrid of the grid 140 and the power amount Ppcs of the PCS 120. For example, the power amount Ptotal_load may be calculated by Equation 1.

【Equation 1】

$$P_{total\text{-}load} = P_{load1} + P_{load2} = P_{grid} - P_{pcs}$$

For example, the power amount Pgrid of the grid and the power amount Ppcs of the PCS may be calculated by Equation 2 and Equation 3, respectively.

【Equation 2】

$$P_{grid} = P_u + P_w = v_u \cdot i_u + v_w \cdot i_w$$

【Equation 3】

$$P_{pcs} = v_{pcs\text{-}out} \cdot i_{pcs\text{-}out}$$

Here, the power amount Ppcs of the PCS is a value corresponding to the charged power amount of the battery 110 controlled by the processor 121.

FIG. 4 is a view illustrating another example of a detailed circuit diagram of an energy storage system according to an embodiment.

FIG. 4 shows an example in which an ESS 102 is a single-phase 2-wire system. For example, in the ESS 102, the load 130 is connected between the PCS 120 and the grid 140, and one CT 203 is connected between the load 130 and the grid 140.

In the same manner as described above with reference to FIG. 3, the power amount Ptotal_load of the load 130 may be identified through the difference between the power amount Pgrid of the grid 140 and the power amount Ppcs of the PCS 120.

FIG. 5 is a view illustrating an example of an equivalent circuit diagram of an energy storage system according to an embodiment.

In FIG. 5, the ESS 101 of FIG. 3 and the ESS 102 of FIG. 4 are schematically schematized. In addition, as described above with reference to FIG. 3, the power amount Ppcs of the PCS 120 is a value corresponding to the charged power amount of the battery 110 controlled by the processor 121.

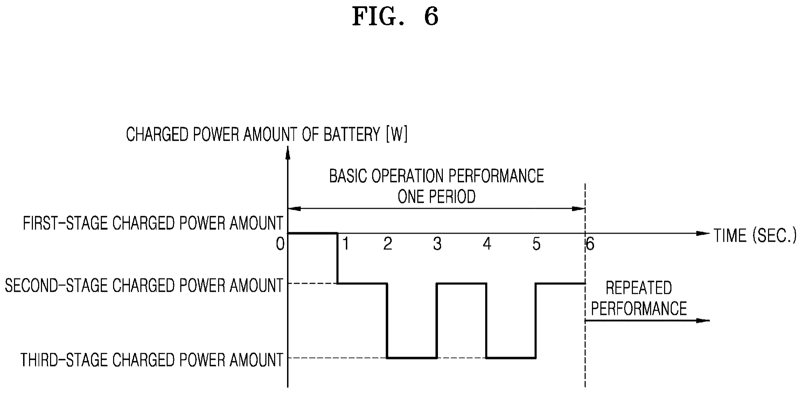

FIG. 6 is a graph illustrating an example in which the amount of charging power of a battery is controlled according to an embodiment.

FIG. 6 shows a graph illustrating a waveform in which the charged power amount of the battery 110 changes during a predefined period of time.

The processor 121 may apply a control signal (hereinafter referred to as a 'charging control signal') that changes the charged power amount of the battery 110. Here, the charged power amount included in the charging control signal may be changed. For example, between 0 and 1 second, a charging control signal indicating a first-stage charged power amount is applied, and between 1 and 6 seconds, a charging control signal indicating a second-stage charged power amount and a charging control signal indicating a third-stage charged power amount may be applied alternately.

Here, the first-stage charged power amount may be the reference value described above with reference to operation S10 of FIG. 2. For example, the processor 121 may identify the first power amount of the load 130 using the first-stage charged power amount.

Thereafter, the processor 121 may identify the second power amounts of the load 130 while changing the charged power amount to the second stage or the third stage.

For example, in order to increase the accuracy and reliability of the algorithm, the basic operation performance period may be set to a very short time of several seconds, and the charged power amount of the battery 110 may be rapidly changed to be applied in a stepwise manner. Here, the maximum/minimum value of the charged power amount according to the charging control signal has to not exceed the rated capacity of the system and has to be set within a power operation range in which the stability of the battery 110 is ensured. Meanwhile, if a change period of the charged power amount of the battery 110 is relatively long or the difference between power amounts for each stage is insignificant (for example, within a few percent of the total rating), the processor may operate unintentionally depending on errors and actual load conditions.

In other words, the core of the algorithm is to rapidly derive the power amount of the load in each section by significantly changing the charged power amount of the battery 110 within a short period of time.

The processor 121 identifies whether the power amount of the load 130 excessively fluctuates during one basic operation period, and detects incorrect installation of the measurement device 200 based on the number of excessive fluctuations during a plurality of periods.

According to an embodiment, the processor 121 measures the power amount of the load 130, while rapidly changing the charged power amount of the battery 110 within a short period of time to identify whether there is a change in the power amount of the load 130.

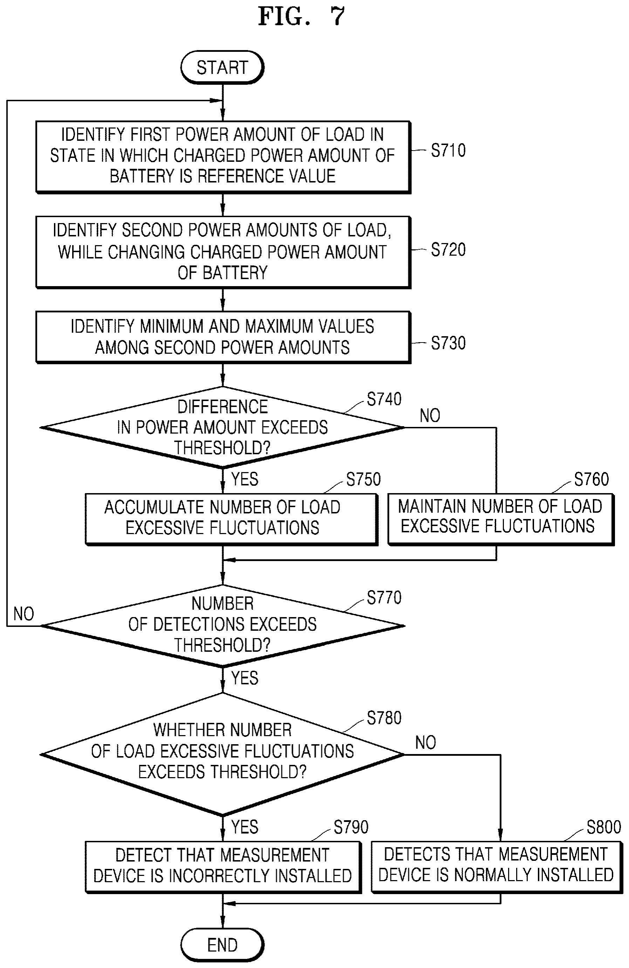

FIG. 7 is a flowchart illustrating an example in which an energy storage system operates according to an embodiment.

FIG. 7 shows the operation of the processor 121 shown in FIG. 2 in more detail. Therefore, hereinafter, detailed description of contents that overlaps what was described above with reference to FIG. 2 is omitted.

In operation S710, the processor 121 identifies the first power amount of the load in a state in which the charged power amount of the battery is the reference value.

In operation S720, the processor 121 identifies the second power amounts of the load, while changing the charged power amount of the battery within one period.

In operation S730, the processor 121 identifies the minimum and maximum values among the second power amounts of the load.

In operation S740, the processor 121 identifies whether the difference between the first power amount and the minimum and maximum values of the second power amounts exceeds a threshold.

If the difference in power amount exceeds the threshold (Yes in S740), in operation S750, the processor 121 accumulates the number of load excessive fluctuations.

If the difference in power amount does not exceed the threshold (No in S740), the processor 121 maintains the number of load excessive fluctuations in operation S760.

In operation S770, the processor 121 identifies whether the number of detections (the number of measured excessive fluctuations) exceeds a threshold. The reason why operation S770 is performed is because the number of times excessive fluctuation is measured has to be more than a certain number to serve as a reliable indicator for determining whether the measurement device 200 is incorrectly installed.

If the number of detections does not exceed the threshold (No in S770), the processor 121 returns to operation S710 and performs one more cycle of detecting whether the load excessively fluctuates.

If the number of detections exceeds the threshold (Yes in S770), in operation S780, the processor 121 determines whether the number of load excessive fluctuations exceeds the threshold.

If the number of load excessive fluctuations exceeds the threshold (Yes in S780), in operation S790, the processor 121 detects that the measurement device 200 is incorrectly installed.

If the number of load excessive fluctuations does not exceed the threshold (No in S780), in operation S800, the processor 121 detects that the measurement device 200 is normally installed.

FIG. 8 is a view illustrating another example of a detailed circuit diagram of an energy storage system according to an embodiment.

Comparing FIGS. 3 and 8, an ESS 103 is a single-phase 3-wire system like the ESS 101 in FIG. 3, but the measurement device is an EM 204 rather than the CT 201 or 202 in FIG. 3.

Because the EM 204 may immediately measure the power amount of a grid 150, the processor 121 does not need to calculate the power amount of the grid 150. Accordingly, there is an advantage in that the calculation process of the processor 121 is reduced.

FIG. 9 is a view illustrating another example of a detailed circuit diagram of an energy storage system according to an embodiment.

Comparing FIGS. 4 and 9, an ESS 104 is a single-phase, 2-wire system like the ESS 102 in FIG. 4, but the measurement device is an EM 205, rather than the CT 203 in FIG. 3.

As described above with reference to FIG. 8, the EM 205 may immediately measure the power amount of the grid 150, so the processor 121 does not need to calculate the power amount of the grid 150. Accordingly, there is an advantage in that a calculation process of the processor 121 is reduced.

Meanwhile, the aforementioned method may be written as a program that may be executed on a computer and may be implemented in a general-purpose digital computer that operates the program using a computer-readable recording medium. In addition, a data structure used in the aforementioned method may be recorded on a computer-readable recording medium through various units. The computer-readable recording medium includes storage medium, such as magnetic storage medium (e.g., ROM, RAM, USB, floppy disk, hard disk, etc.) and optical read medium (e.g., CD-ROM, DVD, etc.).

Those skilled in the art related to the present embodiment will understand that the present disclosure may be implemented in a modified form without departing from the essential characteristics. Therefore, the disclosed methods should be considered from an explanatory rather than a limiting perspective, and the scope is indicated in the claims, not the foregoing description, and should be interpreted to include all differences within the equivalent scope.

**Claims**

1. An energy storage system comprising:

   a processor configured to
   identify a first power amount of a load using first measurement information received from at least one measurement device,
   identify second power amounts of the load using second measurement information received from the measurement device according to a change in a charged power amount of a battery,
   identify power excessive fluctuation of the load based on a difference between the first power amount and the second power amounts, and
   detect incorrect installation of the measurement device based on the number of times the power excessive fluctuation has occurred.

**2.** The energy storage system of claim 1, wherein

the first power amount includes
a reference power amount when the charged power amount of the battery is a reference value.

**3.** The energy storage system of claim 1, wherein

the measurement device includes
a current transducer (CT) or an energy meter (EM).

**4.** The energy storage system of claim 1, wherein

the processor is further configured to
identify a minimum value and a maximum value among the second power amounts, and
when a difference between the first power amount and any one of the minimum value and the maximum value exceeds a predefined value, the processor identifies that the power excessive fluctuation has occurred.

**5.** The energy storage system of claim 1, wherein

the processor is further configured to
identify a power amount of a grid using measurement information received from the measurement device and
identify a power amount of the load through a difference between the power amount of the grid and the charged power amount of the battery.

**6.** The energy storage system of claim 1, wherein

the processor is further configured to
change the charged power amount of the battery by repeatedly raising and lowering the charged power amount of the battery in stages within a predefined time.

**7.** The energy storage system of claim 6, wherein

the processor is further configured to
accumulatively identify the number of times the power excessive fluctuation has occurred during a plurality of periods based on the predefined time as one period.

**8.** A method for detecting incorrect installation of at least one measurement device, the method comprising:

identifying a first power amount of a load using first measurement information received from at least one measurement device;
identifying second power amounts of the load using second measurement Information received from the measurement device according to a change in a charged power amount of a battery;
identifying power excessive fluctuation of the load based on a difference between the first power amount and the second power amounts; and
detecting incorrect installation of the measurement device based on the number of times the power excessive fluctuation has occurred.

**9.** The method of claim 8, wherein

the first power amount includes
a reference power amount when the charged power amount of the battery is a reference value.

**10.** The method of claim 8, wherein

the measurement device includes
a current transducer (CT) or an energy meter (EM).

**11.** The method of claim 8, wherein
the identifying power excessive fluctuation of the load includes:

identifying a minimum value and a maximum value among the second power amounts; and
if a difference between the first power amount and any one of the minimum value and the maximum value exceeds a predefined value, identifying that the power excessive fluctuation has occurred.

**12.** The method of claim 8, wherein
the identifying of the first power amount and the second power amounts of the load includes:

identifying a power amount of a grid using measurement information received from the measurement device; and
identifying a power amount of the load through a difference between the power amount of the grid and the charged power amount of the battery.

**13.** The method of claim 8, wherein
the identifying of the second power amounts of the load includes:
changing the charged power amount of the battery by repeatedly raising and lowering the charged power amount of the battery in stages within a predefined time.

**14.** The method of claim 13, wherein
the detecting of incorrect installation of the measurement device includes:

accumulatively identifying the number of times power excessive fluctuation has occurred during a plurality of periods based on the predefined time as one period.

15. A computer-readable recording medium having recorded a program for causing a computer to execute the method of claim 8.

# FIG. 1

# FIG. 2

START

IDENTIFY FIRST POWER AMOUNT USING FIRST MEASUREMENT INFORMATION RECEIVED FROM AT LEAST ONE MEASUREMENT DEVICE — S10

IDENTIFY SECOND POWER AMOUNT OF LOAD USING SECOND MEASUREMENT INFORMATION RECEIVED FROM MEASUREMENT DEVICE ACCORDING TO CHANGE IN CHARGED POWER AMOUNT OF THE BATTERY — S20

IDENTIFY POWER EXCESSIVE FLUCTUATION OF LOAD BASED ON DIFFERENCE BETWEEN FIRST POWER AMOUNT AND SECOND POWER AMOUNT — S30

DETECT INCORRECT INSTALLATION OF MEASUREMENT DEVICE BASED ON NUMBER OF TIMES POWER EXCESSIVE FLUCTUATION HAS OCCURRED — S40

END

# FIG. 3

# FIG. 4

FIG. 5

## FIG. 6

CHARGED POWER AMOUNT OF BATTERY [W]

BASIC OPERATION PERFORMANCE
ONE PERIOD

FIRST-STAGE CHARGED POWER AMOUNT

TIME (SEC.)

0   1   2   3   4   5   6

SECOND-STAGE CHARGED POWER AMOUNT

REPEATED
PERFORMANCE

THIRD-STAGE CHARGED POWER AMOUNT

EP 4 692 829 A1

# FIG. 7

START

IDENTIFY FIRST POWER AMOUNT OF LOAD IN STATE IN WHICH CHARGED POWER AMOUNT OF BATTERY IS REFERENCE VALUE — S710

IDENTIFY SECOND POWER AMOUNTS OF LOAD, WHILE CHANGING CHARGED POWER AMOUNT OF BATTERY — S720

IDENTIFY MINIMUM AND MAXIMUM VALUES AMONG SECOND POWER AMOUNTS — S730

DIFFERENCE IN POWER AMOUNT EXCEEDS THRESHOLD? — S740

NO

YES — S750

ACCUMULATE NUMBER OF LOAD EXCESSIVE FLUCTUATIONS — S750

MAINTAIN NUMBER OF LOAD EXCESSIVE FLUCTUATIONS — S760

NUMBER OF DETECTIONS EXCEEDS THRESHOLD? — S770

NO

YES

WHETHER NUMBER OF LOAD EXCESSIVE FLUCTUATIONS EXCEEDS THRESHOLD? — S780

NO

YES — S790

DETECT THAT MEASUREMENT DEVICE IS INCORRECTLY INSTALLED — S790

DETECTS THAT MEASUREMENT DEVICE IS NORMALLY INSTALLED — S800

END

# FIG. 8

# FIG. 9

## INTERNATIONAL SEARCH REPORT

| International application No. |
|---|
| **PCT/KR2024/003689** |

### A. CLASSIFICATION OF SUBJECT MATTER

**G01R 31/40**(2006.01)i; **G01R 22/06**(2006.01)i; **G01R 15/18**(2006.01)i; **G01R 31/382**(2019.01)i

According to International Patent Classification (IPC) or to both national classification and IPC

### B. FIELDS SEARCHED

Minimum documentation searched (classification system followed by classification symbols)

G01R 31/40(2006.01); G01R 19/00(2006.01); G01R 31/36(2006.01); H02H 1/00(2006.01); H02H 3/42(2006.01); H02J 9/00(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 계측 장치(measuring device), 전력량(power quantity), 부하(load), 배터리(battery), 충전(charging), 과변동(overvariation), 오설치(incorrect installation), 프로세서(processor), 에너지 저장 시스템(energy storage system)

### C. DOCUMENTS CONSIDERED TO BE RELEVANT

| Category* | Citation of document, with indication, where appropriate, of the relevant passages | Relevant to claim No. |
|---|---|---|
| Y | KR 10-2022-0039990 A (HYUNTAI CO., LTD.) 30 March 2022 (2022-03-30)<br>See paragraphs [0031]-[0066]; claims 1-5; and figures 1-3. | 1-15 |
| Y | KR 10-0146269 B1 (INTERNATIONAL BUSINESS MACHINES CORPORATION) 01 October 1998 (1998-10-01)<br>See paragraph [0018]; and claim 1. | 1-15 |
| A | US 2022-0094153 A1 (ERP POWER, L.L.C.) 24 March 2022 (2022-03-24)<br>See paragraphs [0028]-[0066]; and figures 1-2. | 1-15 |
| A | KR 10-2017-0050519 A (POSCO ICT COMPANY LTD.) 11 May 2017 (2017-05-11)<br>See claims 1-5; and figures 1-2. | 1-15 |
| A | KR 10-2017-0048992 A (LG ELECTRONICS INC.) 10 May 2017 (2017-05-10)<br>See paragraphs [0023]-[0123]; and figures 1-2. | 1-15 |

☐ Further documents are listed in the continuation of Box C.  ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **26 June 2024** | **27 June 2024** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**INTERNATIONAL SEARCH REPORT**
Information on patent family members

International application No.

**PCT/KR2024/003689**

| Patent document cited in search report | | | Publication date (day/month/year) | Patent family member(s) | | | Publication date (day/month/year) |
|---|---|---|---|---|---|---|---|
| KR | 10-2022-0039990 | A | 30 March 2022 | KR | 10-2480440 | B1 | 30 December 2022 |
| KR | 10-0146269 | B1 | 01 October 1998 | CN | 1044953 | C | 01 September 1999 |
| | | | | CN | 1099149 | C | 15 January 2003 |
| | | | | CN | 1111845 | A | 15 November 1995 |
| | | | | CN | 1222001 | A | 07 July 1999 |
| | | | | DE | 000004402716 | A1 | 03 August 1995 |
| | | | | DE | 000004402716 | C2 | 29 August 1996 |
| | | | | EP | 0665443 | A1 | 02 August 1995 |
| | | | | JP | 07-231584 | A | 29 August 1995 |
| | | | | JP | 2848554 | B2 | 20 January 1999 |
| | | | | KR | 10-1995-0024392 | A | 21 August 1995 |
| | | | | MY | 113993 | A | 31 July 2002 |
| | | | | US | 5552953 | A | 03 September 1996 |
| US | 2022-0094153 | A1 | 24 March 2022 | US | 11495958 | B2 | 08 November 2022 |
| KR | 10-2017-0050519 | A | 11 May 2017 | KR | 10-1782223 | B1 | 26 September 2017 |
| KR | 10-2017-0048992 | A | 10 May 2017 | JP | 2017-085867 | A | 18 May 2017 |
| | | | | JP | 6266700 | B2 | 24 January 2018 |
| | | | | KR | 10-2017-0047821 | A | 08 May 2017 |
| | | | | KR | 10-2463396 | B1 | 04 November 2022 |

Form PCT/ISA/210 (patent family annex) (July 2022)